# EUROPÄISCHE PATENTSCHRIFT

(11) **EP 2 898 531 B1**
(45) Veröffentlichungstag und Bekanntmachung des Hinweises auf die Patenterteilung: **11.03.2020**
(21) Anmeldenummer: 13763096.8
(22) Anmeldetag: 19.09.2013
(51) Int. Cl.: H01L 29/78, H01L 29/06, H01L 29/10, H01L 21/336, H01L 29/08, H01L 29/423

(54) **NMOS-TRANSISTOR UND VERFAHREN ZU SEINER HERSTELLUNG**
NMOS TRANSISTOR AND METHODS OF MAKING THE SAME
TRANSISTOR NMOS ET SES MÉTHODES DE FABRICATION

(30) Priorität: 21.09.2012 DE 102012217044
(43) Veröffentlichungstag der Anmeldung: 29.07.2015
(73) Patentinhaber: Elmos Semiconductor Aktiengesellschaft, 44227 Dortmund (DE)
(72) Erfinder: KUEHNHOLD, Ralf, 44227 Dortmund (DE); ROTTER, Thomas, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2013/069462
(87) Internationale Veröffentlichungsnummer: WO 2014/044748

(56) Entgegenhaltungen:
- WO-A1-00/35020
- US-A1- 2011 241 114
- US-B1- 7 868 378

## Beschreibung

Die Erfindung betrifft ein Verfahren zur Herstellung eines NMOS-Transistors, der insbesondere bei hohen Substratspannungen eingesetzt werden kann.

Transistoren werden unter anderem als Highside- oder Lowside-Schalter eingesetzt. Die Problematik bei insbesondere NMOS-Transistoren in ihrer Anwendung als Highside-Schalter besteht in der Aufrechterhaltung der "vertikalen" Isolation, d.h. der Isolation des NMOS-Transistors gegenüber dem Substrat. Dies gilt insbesondere dann, wenn derartige Transistoren bei hohen Substratspannungen eingesetzt werden, z.B. in Brückenschaltungen innerhalb einer integrierten Gesamtschaltung, in denen gleichzeitig Lowside- und Highside-Schalter zum Einsatz kommen.

NMOS-Transistoren für den oben angegebenen Anwendungsbereich lassen sich beispielsweise in Hochvolt (HV)-CMOS Techniken (US-B-8 129 782, US-A-2011/0180870) oder Bipolar-CMOS-DMOS (BCD)-Techniken (US-A-2010/0096697, US-A-2011/0241092) realisieren.

Zur Verbesserung der Kompromiss-Situation zwischen Durchbruchspannung und Einschaltwiderstand wird dabei im Bereich der Driftzone z.B. eines nLDMOS-Transistors ein zusätzliches Gebiet mit komplementärer Dotierung eingebracht, das zu einem reduzierten Oberflächenfeld innerhalb der Driftzone führt, so dass der Transistor trotz hoher Driftdotierung für größere Drain-Source-Spannungen ausgelegt werden kann. Dieses Vorgehen wird allgemein auch als RESURF (Reduced Surface Field)-Technik bezeichnet (siehe A.W. Ludikhuize, Performance and Innovative Trends in RESURF Technology, Proc. ESSDERC 2001).

In Herstellungsverfahren im Stand der Technik werden die Bestandteile einer Sperrspannungen aufnehmenden Struktur (pBody und n-Driftzone im Feldoxidbereich) meist mittels Lithographie zueinander positioniert. Bei dem aus US-A-2001/0053581 bekannten Transistor wird zudem die stromführende n-Driftzone für die Darstellung eines Lowside-nLDMOS (n-dotierter laterally diffuses MOS) vor Oxidation des LOCOS-Feldstegs selbstjustierend zu letzterem eingebracht.

Im Stand der Technik ist darüber hinaus bekannt, die Transistorstruktur durch die Verwendung einer n-dotierten vergrabenen Schicht (n-buried layer) gegenüber dem Substrat zu isolieren. Diese meist hoch dotierte Schicht verhindert das Wirksamwerden des unvermeidbaren vertikalen parasitären pnp-Transistors, erfordert aber sowohl mindestens einen Implantations- als auch einen Epitaxieschritt, welche üblicherweise innerhalb von BCD-Techniken verfügbar sind. Ein solcher nLDMOS-Transistor wird beispielsweise in US-A-2010/0096697 als Grundstruktur verwendet. Zusätzliche werden dort Modifikationen mittels des Layouts der STI-(shallow-trend isolation)-Aktivgebiete an der Drainseite (drain engineering) beschrieben.

Bei Verwendung einer durch Ionenimplantation und Ausdiffusion eingebrachten HV-(Hochvolt-)nWanne begrenzter Tiefe und Dotierung, wie dies für HV-CMOS Techniken üblich ist, sind zusätzlich die Wechselwirkungen der verwendeten Prozess-Integration mit zu berücksichtigen, da diese erheblichen Einfluss auf die vertikale Isolation haben kann. Dies hat direkten Einfluss auf die Prozessgestaltung zur Herstellung von nLDMOS Transistoren, insbesondere wenn diese als Highside-Schalter agieren sollen.

In US-A-2010/0025756 ist ein EHV (extrem Hochvolt bis zu 700 V) nLDMOS-Transistor gemäß dem Oberbegriff des Anspruchs 1 beschrieben, bei dem der Strom innerhalb der Driftregion in verschiedenen Ebenen (über und unter bzw. auch zwischen) pRESURF-Zonen geführt wird. Zudem erfolgt die Auffächerung des Gesamtstroms innerhalb eines zusammenhängenden Source- und Gate-Bereichs. Die pRESURF-Zone ist dabei explizit getrennt vom sogenannten pBody-Bereich. Erst durch die Gesamtanordnung wird über ein inaktives Randelement ein elektrischer Kurzschluss zwischen den beiden genannten p-Zonen bewirkt (siehe Absatz [00026] in US-A-2010/0025756). Dadurch wird aber die Durchbruchspannung reduziert, da die essentielle p-Wanne zur (vertikalen) Anbindung des pRESURF an den pBody-Bereich auf Grund der hohen Dotierung nur begrenzt verarmbar und dadurch die effektive Länge der Driftzone reduziert wird. Wird das pRESURF dabei nicht elektrisch angebunden an den pBody-Bereich und ist somit floatend, so können It. US-A-2010/0025756 zwar höhere Durchbruchspannungen resultieren, was aber mit nicht deterministischen Einschaltwiderständen erkauft wird. Dokument US 2011/241114 A1 beschreibt einen Hochvolt nLDMOS Transistor gemäß dem Oberbegriff der Ansprüche 1 und 2 und ein Verfahren zu seiner Herstellung, bei dem die Erzeugung der p dotierten Dotierungsausgleichs- bzw. -Kompensationszone erfolgt, bevor eine Abdeckschicht zur Erzeugung von einzelnen, örtlich begrenzten Oxidgebieten auf der Oberseite des Halbleitersubstrats aufgebracht ist. Dokument WO 00/35020 A1 betrifft ein laterales Hochvolt-Halbleiterbauelement, bei dem, sich in lateraler Richtung erstreckende, p- und n-leitende Schichten vorgesehen sind, die durch Implantation erzeugt werden. Dieser Schritt erfolgt vor der Erzeugung von einem örtlich begrenzten Oxidgebiet auf der Oberseite des Halbleitersubstrats. Diese Kompensationshalbleiterschichten können floatend sein oder mit einem Body-SourceBereich verbunden sein.

Aufgabe der Erfindung ist es, ein Verfahren zur Herstellung eines insbesondere für Highside-Anwendungen einsetzbaren NMOS-Transistors, der über ausgezeichnete Spannungsfestigkeiten verfügt, anzugeben.

Zur Lösung dieser Aufgabe wird mit der Erfindung ein Verfahren zur Herstellung eines NMOS-Transistors, insbesondere für hohe Substratspannungen, vorgeschlagen, das gemäß einer ersten Variante die Schritte des Anspruchs 1 und gemäß einer zweiten Variante die Schritte des Anspruchs 2 aufweist. Einzelne Ausgestaltungen der Erfindung sind Gegenstand der Unteransprüche.

Bei dem erfindungsgemäß hergestellten NMOS-Transistor ist die pRESURF-Zone mit dem pBody metallurgisch verbunden, so dass beide ineinander übergehen oder elektrisch leitend verbunden oder die pRESURF-Zone an den pBody elektrisch angebunden.

Bei dem erfindungsgemäß hergestellten NMOS-Transistor befindet sich unterhalb des p-dotierten Bereichs, in dem oberseitig der Kanal ausgebildet ist, direkt die n-Wanne; mit anderen Worten stößt also der pBody unterseitig zumindest in einem Teilgebiet direkt an die n-Wanne an.

Verfahrenstechnisch wird dies dadurch erreicht, dass, bei Einsatz eines LOCOS-Prozesses, mindestens eine Ionenimplantation unter Verwendung einer Implantationsmaske zur Erzeugung der n-dotierten Driftzone und/oder der pRESURF-Zone zu einem Zeitpunkt der Herstellung des NMOS-Transistors erfolgt, zu dem die Abdeckschicht noch nicht von der Oberseite des Halbleitersubstrats abgetragen ist, die Implantationsmaske also auf den lokalen Oxidationsgebieten und der Abdeckschicht aufgetragen wird, oder dass, bei einem STI-Prozess, mindestens eine Ionenimplantation unter Verwendung einer Implantationsmaske zur Erzeugung der n-dotierten Driftzone und/oder der pRESURF-Zone zu einem Zeitpunkt der Herstellung des NMOS-Transistors erfolgt, zu dem die Abdeckschicht noch nicht von der Oberseite des Halbleitersubstrats abgetragen ist, die Implantationsmaske also auf die Oberseite des Halbleitersubstrats und der Abdeckschicht aufgetragen wird.

Durch beispielsweise eine mit entsprechender Energie erfolgende p-Implantation kann erfindungsgemäß die pRESURF-Zone nun innerhalb der n-Wanne (, die insbesondere als Hochvolt-Wanne ausgebildet ist,) ausgeprägt werden, um so eine - wenn möglich universelle - aber niederohmige, n-dotierte Driftzone für Hochvolt-Bauelemente bereitzustellen. Universell in diesem Zusammenhang heißt, dass die Länge der n-dotierten Driftzone auf einfache Weise mit den (Spannungsfestigkeits-)Anforderungen skaliert werden kann, ohne zusätzliche Modifikationen innerhalb der n-dotierten Driftzone selbst durchzuführen. Die pRESURF-Zone dient bekanntermaßen dazu, die Durchbruchspannung der n-dotierten Driftzone, welche durch die n-Dotierung reduziert ist, wieder zu erhöhen. Damit kann der Vorteil der Driftzone, nämlich der geringe Widerstand (R_{DS,ON}) bei gleichbleibender Durchbruchspannung vorteilhaft genutzt werden. Es ist darüber hinaus möglich, dass die eigentliche n-dotierte Driftzone nDRIFT ober- und unterseitig von einer p-implantierten Zone eingeschlossen ist, wobei es sich dann bei der unterhalb der n-dotierten Driftzone angeordneten p-Zone um die eigentliche pRESURF-Zone handelt.

Durch die räumliche Trennung von Kanalbereich (pBody unter Gate) und dem Driftzonenbereich (n-dotierte Driftzone mit pRESURF) können beide Prozessblöcke unabhängig voneinander eingestellt und optimiert werden. Dies ist vorteilhaft im Rahmen einer modularen Prozess-Architektur, wenn bereits nLDMOS-Transistoren, z.B. mit der HV nWanne als Driftzone, innerhalb der Herstellung einer integrierten Gesamtschaltung bereits auf dem etablierten Prozessblock des pBODY-Bereichs beruhen, da eine Interaktion der beiden Bereiche eine gegenseitige Störung, z.B. das Absinken der charakteristischen Schwellspannung, bewirken würde. Letzteres wäre der Fall, wenn der oberflächennahe Teil der nDRIFT den Kanalbereich erreichen oder gar überdecken würde.

Bei Einsatz des erfindungsgemäß hergestellten NMOS-Transistors als Highside-Schalter liegt das Halbleitersubstrat in der Regel auf dem niedrigsten Potential; alle anderen Zonen und Gebiete des NMOS-Transistors führen ein gegenüber dem Substrat höheres Potential, so dass die Gefahr des elektrischen Durchgriffs (Punch-Through) von parasitären (vertikalen) Transistoren zum Substrat besteht. Zur Hochvoltfestigkeit des NMOS-Transistors, d.h. zur Realisierung von NMOS-Transistoren für Drain-Source-Spannungen im Bereich von bis zu 200 V (Hochvoltbereich) dient die Driftzone. Um im Bereich der Driftzone eine erhöhte Dotierung einzubringen, bedient man sich der RESURF-Technik. Die eingebrachte pRESURF-Zone in die Hochvolt n-Wanne bewirkt aber im Allgemeinen eine Verengung bzw. Verringerung der Basisweite des parasitären vertikalen pnp-Transistors. Durch den erfindungsgemäßen Ansatz, dass sich nämlich die pRESURF-Zone nicht mehr, wie beispielsweise nach einer thermischen Diffusion üblich, bis in den Bereich unterhalb des pBody, d.h. lediglich bis in eine Tiefe auf dem Niveau der Unterseite des pBody, erstreckt, verbleibt damit erfindungsgemäß als Basisweite des unvermeidbaren vertikalen pnp-Transistors im Wesentlichen der Abstand der Unterseite des pBody bis zum Boden der n-dotierten Wanne, d.h. bis zum p-Substrat. Insoweit ist also erfindungsgemäß weiterhin eine gute Highside-Fähigkeit des NMOS-Transistors gegeben, wobei dieser Transistor zusätzlich bezüglich seiner Drain-Source-Spannung hochspannungsfest ist.

Erfindungsgemäß sind also die pRESURF-Zone und der pBody direkt elektrisch verbunden, wodurch ein Elektronen-Stromtransport nur oberhalb der pRESURF-Zone möglich ist. Dadurch kann bei dem erfindungsgemäß hergestellten NMOS-Transistor eine Aktivierung des unerwünschten PNP-Transistors in vertikaler Richtung weitestgehend unterdrückt werden, und zwar sowohl im Betrieb des erfindungsgemäß hergestellten Transistors als passive pBody-Diode als auch bei bewußter Gateansteuerung im Freilauffall.

Durch die erfindungsgemäße Prozessführung wird
a) die pRESURF-Zone innerhalb der Driftzone sicher und direkt am pBody kontaktiert. Eine floatende pRESURF-Zone würde ansonsten zu transient schwankenden Widerstandswerten führen, da sich eine floatende pRESURF-Zone nur durch thermische Generation an ihren Gleichgewichtszustand (etwa beim Schalten vom gesperrten in den leitenden Zustand des Transistors) annähern könnte;
b) die effektive Tiefe der pRESURF-Zone innerhalb der n-dotierten Wanne und insbesondere im Bereich des Source-Aktivgebiets reduziert, womit sich die Highside-Fähigkeit des NMOS-Transistors nicht wesentlich vermindert; denn durch die reduzierte Tiefe, in der die pRESURF-Zone in der n-dotierten Wanne positioniert ist, erhöht sich korrespondierend zur reduzierten Tiefe die (vertikale) Basisweite, d.h. der vertikale Abstand der pRESURF-Zone zum Grund der n-dotierten Wanne des vertikalen parasitären pnp-Transistors (dessen Emitter die pRESURF-Zone und dessen Kollektor das p-Halbleitersubstrat ist);
c) gleichzeitig die strom-/elektronenführende Schicht der n-dotierten Driftzone ebenfalls im Bereich des Source-Aktivgebiets mehr an die Oberfläche herangeführt, was den resultierenden Driftbahn-Widerstand reduziert.

Prozesstechnisch bedingte Dejustagen zwischen dem pRESURF- und dem (bereits etablierten) pBody-Bereich lassen sich nie ganz vermeiden. Durch eine dem Stand der Technik entsprechende, um den Sourcebereich spiegelsymmetrische Anordnung innerhalb des Transistorlayouts kann aber eine elektrische Anbindung nach a) in jedem Fall sichergestellt werden, was auch innerhalb von US-A-2010/0025756 unter Abschnitt [0026] festgehalten wird.

Insbesondere was die beiden zuvor genannten Punkte b) und c) betrifft, ist mit Vorteil anzumerken, dass die Einbringung der pRESURF-Zone durch Ionenimplantation eben gerade keine Veränderung des thermischen Regimes in den nachfolgenden Herstellungsprozessschritten erforderlich macht; insbesondere folgt auf die Einbringung der Implantation zur Erzeugung der pRESURF-Zone keine Diffusion mit einem hohem thermischen Budget mehr. Dies bedeutet, dass die elektrische Aktivierung der eingebrachten Dotierstoffe zwar durch thermische Aufheilverfahren bewirkt wird, eine maßgeblich thermisch bedingte Diffusion mit Diffusionslängen im Bereich über 500 nm aber unterbleibt.

Das erfindungsgemäße Konzept lässt sich auch auf die Herstellung von Hochvolt-PMOS-Transistoren übertragen; dann allerdings würden im Bereich der Driftzone nicht nur, wie bei Anwendung der Erfindung auf einen NMOS-Transistor, lediglich zwei pn-Übergänge sondern sogar drei oder mehr pn-Übergänge entstehen.

Weiterhin kann mit Vorteil vorgesehen sein, dass die n-dotierte Driftzone und/oder die pRESURF-Zone in einem Abstand zur Seitenbegrenzung der n-Wanne endet. Dies ist insbesondere zur Ausgestaltung von high-side fähigen Transistoren erforderlich.

Ferner ist es möglich, dass die n-dotierte Driftzone und/oder die pRESURF-Zone bereits unter oder neben dem Drain-Anschlussgebiet endet. Im Drainbereich des Transistors ist somit in vertikaler Richtung mitunter nur ein pn-Übergang präsent, während in der BCD-Grundstruktur des Transistors nach US-A-2010/0096697 mehrere pn-Übergänge ausgebildet sind.

Gemäß einem weiteren Aspekt der Erfindung kann vorgesehen sein, dass die n-dotierte Driftzone am drainseitigen Ende in eine weitere n-Wanne übergeht oder dort verstärkt ist. Durch den vorteilhaften Einsatz von verschiedenen Implantationsebenen kann also insbesondere eine zum Drain hin ansteigende Dotierung modelliert werden, welche als optimal für die Kompromiss-Situation zwischen niedrigem R_{DS,ON} und hoher Durchbruchspannung angesehen wird (siehe Chenming Hu, Optimum Doping Profile for Minimum Ohmic Resistance and High-Breakdown Voltage, IEEE Trans. El. Dev. 26 (3), 243 (1979)).

Was die Ausbildung des Gates betrifft, so kann die Gate-Isolationsschicht in einem Teilbereich, in dem sie sich über die n-dotierte Driftzone erstreckt, eine größere Dicke (sogenannte Feldplatte) aufweisen, als in ihrem Teilbereich über dem Source-Anschlussgebiet, dem pBody und dem an diesen angrenzenden Bereich der n-dotierten Driftzone.

Gemäß einer weiteren vorteilhaften Ausgestaltung der Erfindung reicht die n-dotierte Driftzone bis zur Oberseite des Halbleitersubstrats. Es ist aber auch denkbar, dass oberhalb der n-dotierten Driftzone zur weiteren Verringerung des EIN-Widerstandes (R_{DS,ON}) des Transistors bei im Wesentlichen gleichbleibendem Durchbruchsvermögen eine sich insbesondere bis zur Oberseite des Halbleitersubstrats erstreckende, oberseitige p-dotierte Zone ausgebildet ist - wie auch durch ein Ausführungsbeispiel belegt wird.

In weiterer vorteilhafter Ausgestaltung der Erfindung erstreckt sich das Gate auf der Halbleitersubstratoberseite über den pBody und bis über die n-dotierte Driftzone einschließlich des Angrenzungsbereichs des Source-Gebiets.

Bei Einsatz eines STI-Herstellungsprozesses kann die mindestens eine Ionenimplantationsebene zur Erzeugung der Driftzone und der pRESURF-Zone zeitlich vor oder zeitlich nach der Graben-Ätzung des Halbleitersubstrats durchgeführt werden, wobei ferner vorgesehen sein kann, dass diese Ionenimplantationsschritte zu einem Zeitpunkt erfolgen, zu dem die geätzten STI-Gräben im Halbleitersubstrat noch nicht bzw. noch nicht vollständig mit Isolationsmaterial aufgefüllt sind.

Gemäß einem weiteren herstellungsbezogenen Aspekt der Erfindung kann zur Durchführung der Ionenimplantationsschritte zur Bildung der n-dotierten Driftzone und der pRESURF-Zone dieselbe Implantationsmaske verwendet werden. Wie bereits oben angeklungen, wird die Tiefe und Ausdehnung der n-dotierten Driftzone und/oder der pRESURF-Zone ohne gezielte thermische Diffusion im Wesentlichen durch die Implantationsparameter (Energie und Einschusswinkel) definiert.

Die Erfindung wird nachfolgend anhand mehrerer Ausführungsbeispiele und unter Bezugnahme auf die Zeichnung näher erläutert. Im Einzelnen zeigen dabei:
- Fig. 1: eine Schnittansicht durch den erfindungsgemäß hergestellten NMOS-Transistor,

- Fign. 2 bis 6: Schnittansichten zu verschiedenen Phasen der Herstellung des NMOS-Transistors unter Verwendung einer LOCOS-Technologie,
- Fign. 7 bis 9: Schnittansichten zu verschiedenen Phasen der Herstellung des NMOS-Transistors unter Verwendung einer STI-Technologie, wobei die Wannenausbildung unvollständig ist,
- Fign. 10 bis 12: Schnittansichten zu verschiedenen Phasen der Herstellung des NMOS-Transistors unter Verwendung einer STI-Technologie, wobei hier die Wannenausbildung vollständig ist,
- Fig. 13: eine Schnittdarstellung eines unter Verwendung eines STI-Prozesses hergestellten NMOS-Transistors ähnlich dem gemäß Fig. 9 und
- Fign. 14 bis 16: Schnittansichten zu verschiedenen Phasen der Herstellung des NMOS-Transistors unter Verwendung einer STI-Technologie mit einer zusätzlichen p-Implantation oberhalb der Driftzone und damit oberseitig des Halbleitersubstrats.

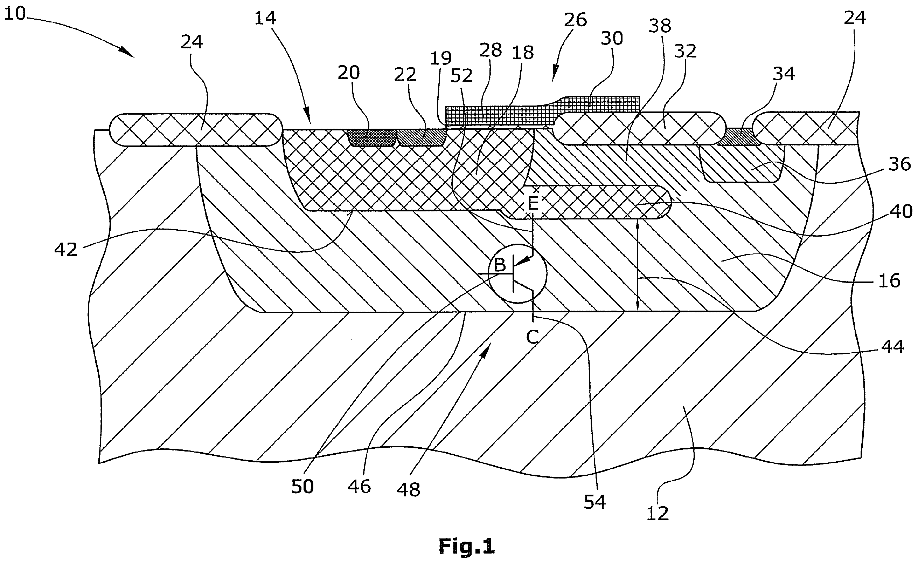

Fig. 1 zeigt schematisch im Querschnitt den Aufbau eines NMOS-Transistors 10, der erfindungsgemäß hergestellt ist. Der NMOS-Transistor 10 ist in einem (p-dotierten) p-Halbleitersubstrat 12 (beispielsweise Silizium) ausgebildet, und zwar im Bereich von dessen Oberseite 14, in die eine für Hochvoltanwendungen geeignete (n-dotierte) n-Wanne 16 eingebracht ist. Innerhalb der n-Wanne 16 befindet sich ein p-dotiertes Gebiet 18 (nachfolgend pBody genannt), in dem oberseitig des p-Halbleitersubstrats 12 das Kanalgebiet 19 ausgebildet ist. Das pBody-Gebiet 18 umfasst ein p-dotiertes Anschlussgebiet 20 sowie ein Source-Anschlussgebiet 22, das n-dotiert ist.

Längs der Oberseite des p-Halbleitersubstrats 12 sind in beispielsweise LOCOS-Technologie hergestellte Feldoxidbereiche 24 (z.B. Siliziumoxid) ausgebildet, und zwar außerhalb der n-Wanne 16 (und gegebenenfalls in die n-Wanne teilweise von außen hineinragend). Das Kanalgebiet 19 ist von einem Gate 26 überdeckt, das eine Gate-Isolationsschicht 28 (z.B. Siliziumoxid) mit einer darauf ausgebildeten Gate-Elektrode 30 (beispielsweise als Polysilizium) aufweist. Letztere kann sich im Bedarfsfall als Feldplatte längs der Oberseite 14 des p-Halbleitersubstrats 12 über den Feldoxidsteg 32 innerhalb der Driftzone in Richtung des n-dotierten Drain-Anschlussgebiets 34 erstrecken. Um das Drain-Anschlussgebiet 34 herum innerhalb der n-Wanne 16 kann optional noch eine n-dotierte "Verstärkungszone" 36 ausgebildet sein.

Zur Gewährleistung einer hohen Spannungsfestigkeit bezüglich der Drain-Source-Spannung ist der NMOS-Transistor 10 mit einer (n-dotierten) n-Driftzone 38 versehen, die durch Einbringung einer n-Implantation in die n-Wanne 16 hergestellt worden ist.

Der erfindungsgemäß hergestellte NMOS-Transistor 10 weist eine speziell positionierte und hergestellte Dotierungsausgleichs- bzw. -kompensationszone 40 auf, die p-dotiert ist. Die Besonderheit dieser nachfolgend auch mit pRESURF-Zone bezeichneten Dotierungsausgleichs- bzw. -kompensationszone 40 ist, dass sie im Wesentlichen lateral, d.h. also von der Seite und damit nicht von unten elektrisch an das pBody-Gebiet 18 angeschlossen ist. Die pRESURF-Zone 40 erstreckt sich also nicht längs der Unterseite 42 des pBody-Gebiets 18, sondern im Wesentlichen bis in Höhe der Unterseite 42 des pBody-Gebiets 18, so dass durch die Einbringung der an das pBody-Gebiet 18 angebundenen pRESURF-Zone 40 der Abstand 44 von p-dotierten Bereichen der n-Wanne 16 zu dessen Boden 46 nicht verringert wird. Damit behält der unvermeidbare parasitäre pnp-Transistor 48 seine Eigenschaften bezüglich des Einsetzens des elektrischen Durchgriffs (Punch-Through) bei. Dieser pnp-Transistor 48 wird bekanntlich gebildet durch die n-Wanne 16 als Basis 50, die pRESURF-Zone 40 als Emitter 52 und das p-Halbleitersubstrat 12 als Kollektor 54.

Durch diese Ausgestaltung des NMOS-Transistors 10 wie in Fig. 1 gezeigt, wird also bei Verwendung der pRESURF-Zone der Einschaltwiderstand R_{DS,ON} des Transistors weiter verringert, ohne aber die Durchbruchspannungsfestigkeit des NMOS-Transistors 10 bezüglich der Drain-Source-Spannung zu verschlechtern. Gleichzeitig wird die Highside-Fähigkeit des NMOS-Transistors 10 nicht negativ beeinträchtigt, da ja, wie oben beschrieben, die durch den Abstand 44 bestimmte Weite der Basis 50 des parasitären pnp-Transistors 48 im Wesentlichen unverändert bleibt.

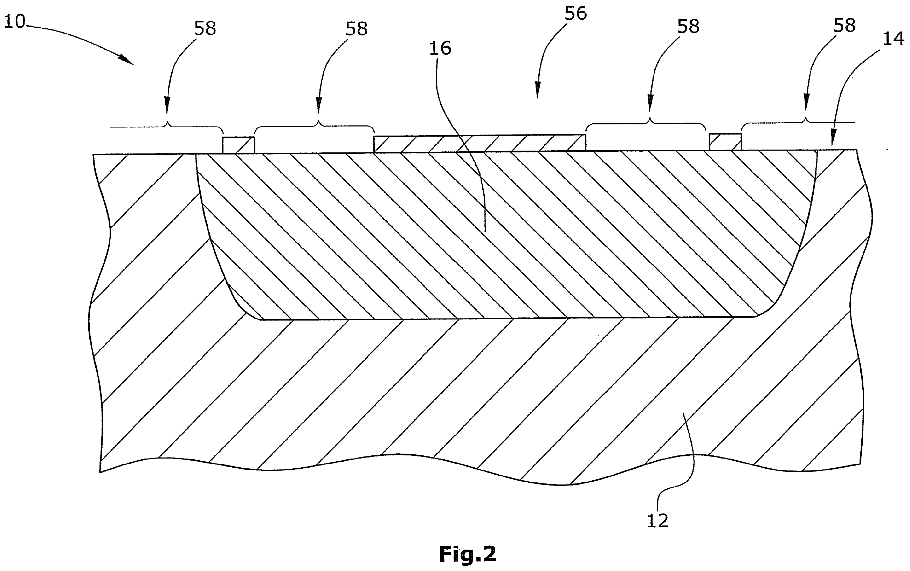

In den Fign. 2 bis 6 ist ein erstes Ausführungsbeispiel eines Verfahrens zur Herstellung des NMOS-Transistors gemäß Fig. 1 schematisch gezeigt, wobei nur ausgewählte Verfahrensschritte wiedergegeben sind. Bei diesem Verfahren wird zur Erzeugung der Feldoxidbereiche 24 eine LOCOS-Technologie eingesetzt.

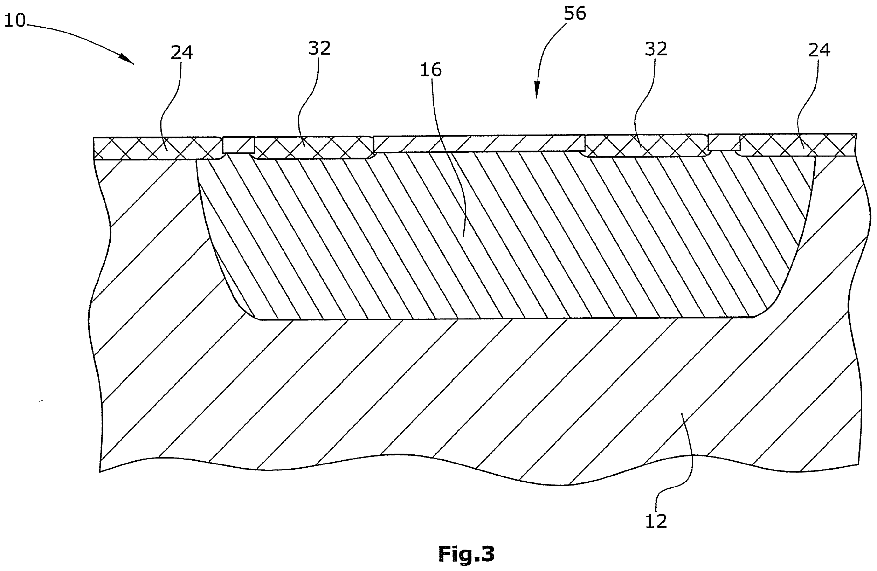

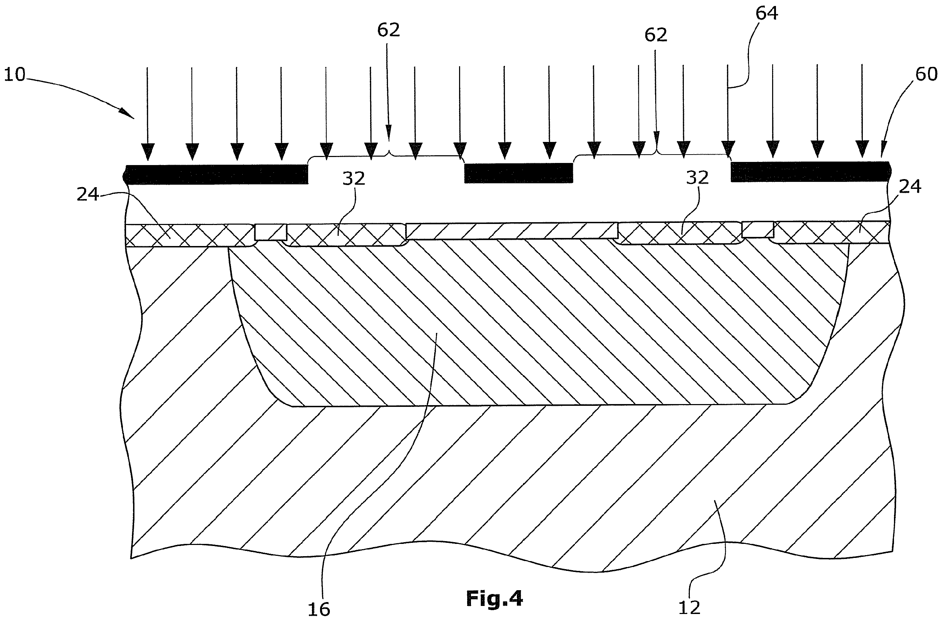

Gemäß Fig. 2 ist in das p-Halbleitersubstrat 12 die n-Wanne 16 eingebracht, während sich auf der Oberseite 14 des p-Halbleitersubstrats 12 bereits die Abdeckschicht 56 (Schichtstapel aus Siliziumoxid und -nitrid) zur selektiven Ausbildung von Oxidationsgebieten an der Oberseite 14 befindet. Innerhalb der Öffnungen 58 der Abdeckschicht 56 entstehen bei der Oxidation die Feldoxidbereiche 24 sowie die Feldoxidstege 32 innerhalb der Driftregion. Dies ist in Fig. 3 gezeigt. Erfindungsgemäß verbleibt die Abdeckschicht 56 oder Reste davon anschließend auf der Oberseite 14 des p-Halbleitersubstrats 12, um in die n-Wanne 16 die Implantationen für die n-Driftzone 38 und für die pRESURF-Zone 40 einzubringen. Dies ist in Fig. 4 gezeigt, in der mit 60 die Implantationsmaske mit ihren Öffnungen 62 und mit den Pfeilen 64 die Implantation bezeichnet ist. Dabei ist zu bemerken, dass für eine vereinfachte Darstellung im Folgenden stets' nur ein Implantationsschritt mit einer gemeinsamen Implantationsmaske angenommen wird. Dies ist aber nicht einschränkend zu verstehen, sondern es ist verallgemeinernd möglich, die beiden Zonen 38,40 innerhalb zweier oder gar mehrerer, auch voneinander unabhängiger Implantationsschritte einzubringen.

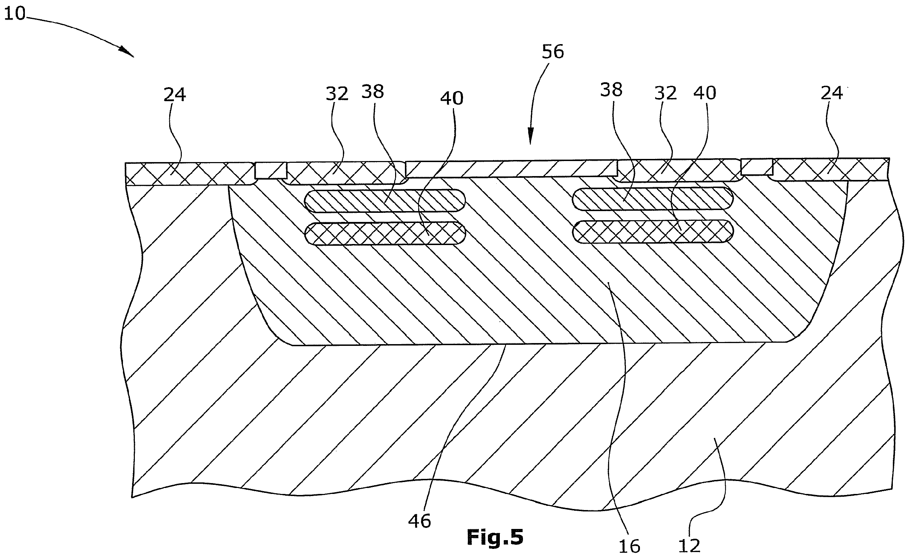

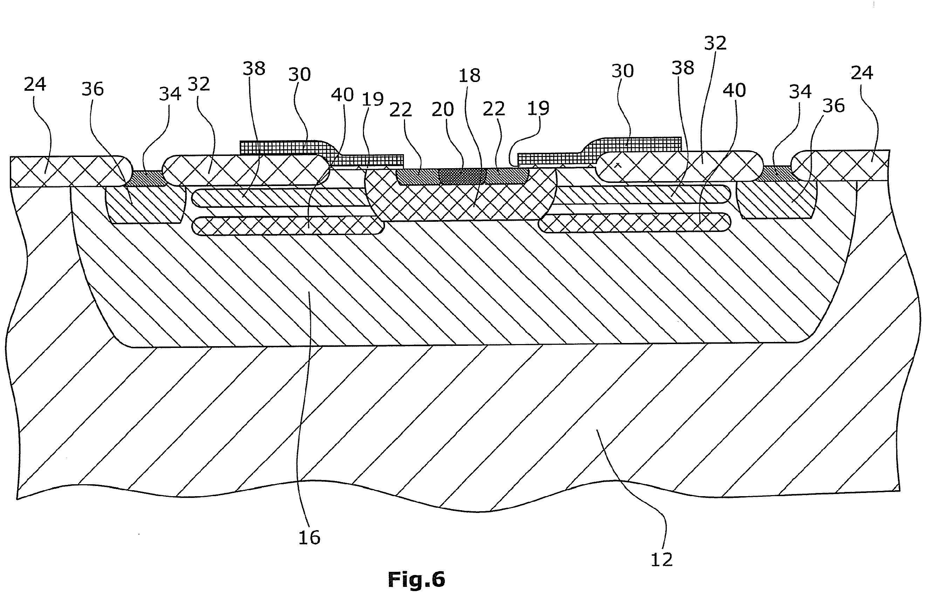

Die beiden implantierten n-Drift- und pRESURF-Zonen 38,40 sind in Fig. 5 gezeigt. Zu erkennen ist insbesondere, dass die pRESURF-Zone 40 an ihrem zum späteren pBody-Gebiet 18 hin weisenden Ende (siehe auch Fig. 6) keinen in Richtung auf den Boden 46 der n-Wanne 16 hin gerichteten, geneigten Bereich aufweist. Letzteres wäre aufgrund der sich dann einstellenden Topologie der Fall, wenn die Bereiche 56 der Abdeckschicht bereits zum Zeitpunkt der Implantation entfernt worden wären. Auch verläuft die pRESURF-Zone 40 ausschließlich seitlich zum späteren pBody-Gebiet 18 (siehe ebenfalls Fig. 6).

Mit dieser im letzten Abschnitt beschriebenen, konventionellen Prozessführung lassen sich zwar ebenso nLDMOS-Transistoren hoher Sperrspannung zwischen Drain und Source herstellen, jedoch wird durch diese konventionelle Art der Prozessführung bei Verwendung einer unter Sperrspannung verarmbaren HV nWanne die vertikale Isolation geschwächt. Dies äußert sich in einem dem Ausführungsbeispiel entsprechenden Transistor in einer (im Betrag) reduzierten Durchbruchspannung BV_CB0 des relevanten pnp-Transistor von typischerweise 65 V statt 74 V bei gleichzeitig höherer Streuung . Letztere Werte werden erzielt, wenn die Prozessführung das oben genannte Ausführungsdetail berücksichtigt. Zusätzlich sind die nLDMOS Transistor nach der hier beschriebenen erfindungsgemäßen Prozessführung geringfügig niederohmiger, was durch eine verbesserte Stromführung innerhalb der eigentlichen nDRIFT Zone begründet ist.

In Fig. 6 sind die übrigen Wesensbestandteile des NMOS-Transistors gemäß diesem Herstellungsverfahren gezeigt. Zu erkennen ist das pBody-Gebiet 18 mit dem pBody-Anschlussgebiet 20 und mit zwei Source-Anschlussgebieten 22. Hierzu ist zu sagen, dass der gemäß diesem Herstellungsverfahren aufgebaute NMOS-Transistor 10 spiegelsymmetrisch zur Source ausgebildet ist, während beispielsweise in Fig. 1 lediglich eine "Hälfte" dieses Transistors, nämlich die rechte Hälfte bezogen auf die Darstellung in Fig. 6, gezeigt ist.

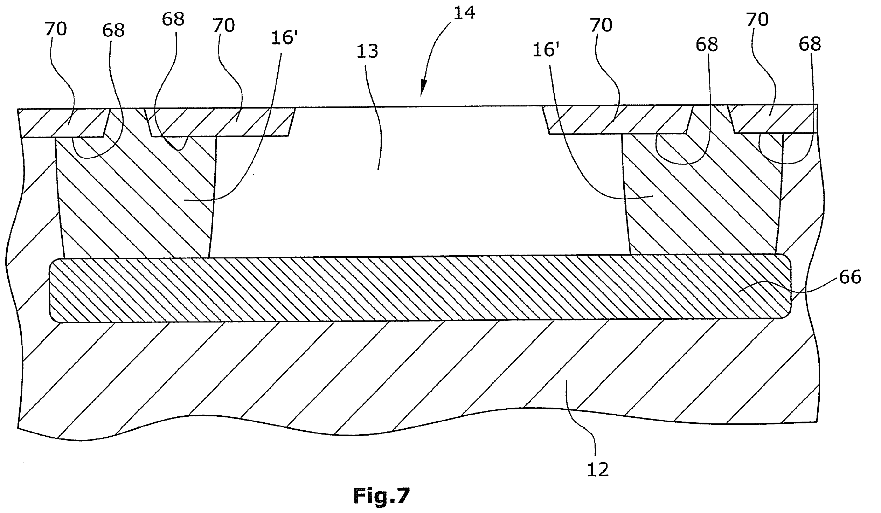

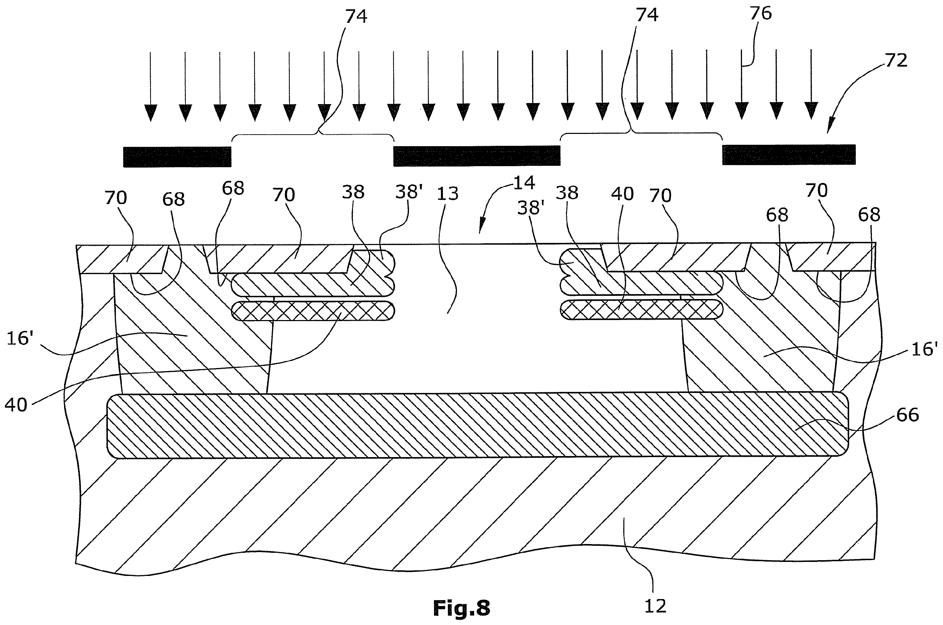

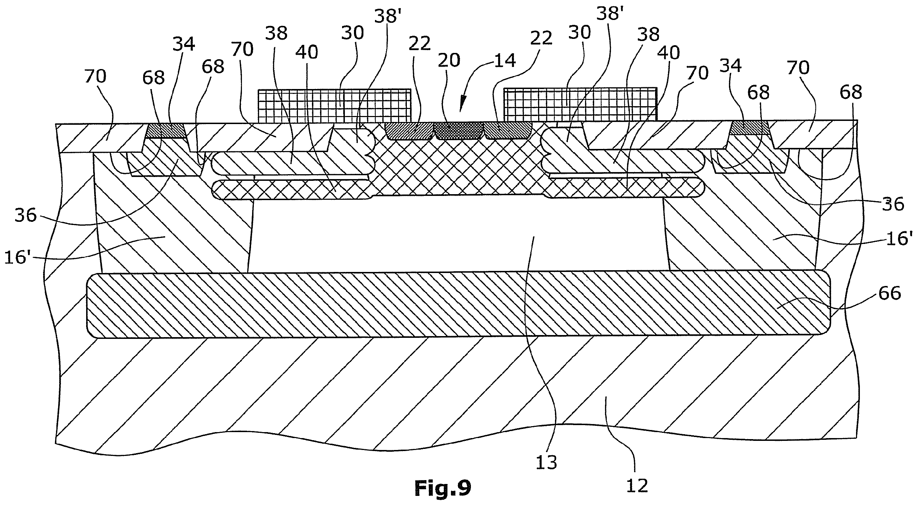

In den Fign. 7 bis 9 sind die wesentlichen Verfahrensschritte zur Herstellung des NMOS-Transistors in STI-Technologie gezeigt. Dabei ist die Ausbildung der n-Wanne 16 noch unvollständig. Zusätzlich ist zur Aufrechterhaltung der Highside-Fähigkeit des NMOS-Transistors eine n-dotierte vergrabene Schicht 66 im Bereich des Bodens der n-Wanne 16 vorgesehen. In der Darstellung gemäß Fig. 7 sind die Vertiefungen 68 in der Oberseite 14 des p-Halbleitersubstrats 12 bereits mit Isolationsmaterial 70 (beispielsweise Siliziumoxid) aufgefüllt. Die noch unvollständig ausgebildete n-Wanne 16 ist nur durch ihre Implantationsteilgebiete 16' repräsentiert, welche durch thermische Diffusion auch ineinander diffundieren können. Die Implantationsteilgebiete 16' werden zwar beabstandet eingebracht (siehe Zwischenraum 13); es erfolgt jedoch eine starke Ausdiffusion, welche derart sein kann, dass auch der pBody unterseitig erreicht wird. Insbesondere bei kleinen Durchbruchspannungen und daraus resultierenden kleinen Abmessungen zwischen den Source- und Drainanschlussgebieten (22,34) ist eine starke Unterdiffusion beobachtbar. Zur Einbringung der Implantationen für die n-Driftzone 38 und die pRESURF-Zone 40 wird gemäß Fig. 8 eine Implantationsmaske 72 mit Öffnungen 74 verwendet. Mit 76 ist die Implantation angedeutet. Die Öffnungen 74 in der Implantationsmaske 72 liegen nun bezogen auf die mit Isolationsmaterial 70 aufgefüllten Oberseitenvertiefungen 68 des p-Halbleitersubstrats 12 derart, dass die aufgefüllten Vertiefungen 68 teilweise mit den projizierten Öffnungen der Implantationsmaske 74 überlappen. Somit entstehen die n-Driftzone 38 und die pRESURF-Zone 40 in der Form, wie in Fig. 8 gezeigt ist. Fig. 9 zeigt dann in Ergänzung die wesentlichen noch fehlenden Bereiche und Dotierungsgebiete, wie sie bei dem erfindungsgemäß hergestellten NMOS-Transistor 10 vorhanden sind. Zu erkennen sind ferner oberseitennahe n-Dotierstoff-Implantationsgebiete 38' zur verbesserten Anbindung des Kanalgebiets 19 an die n-Driftzone 38.

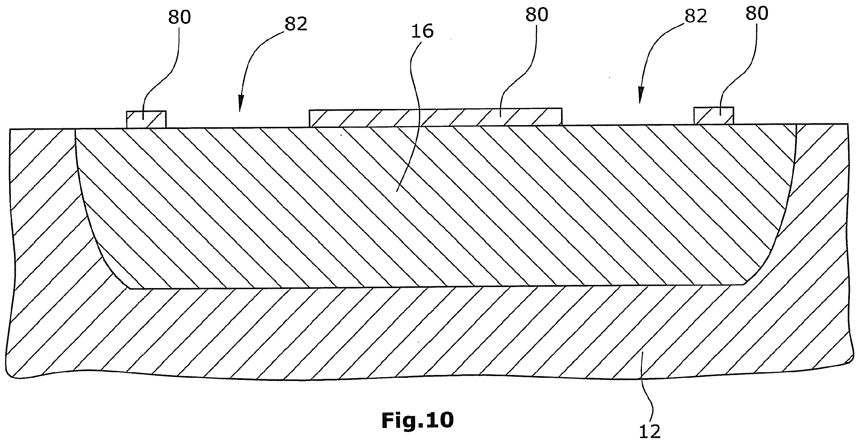

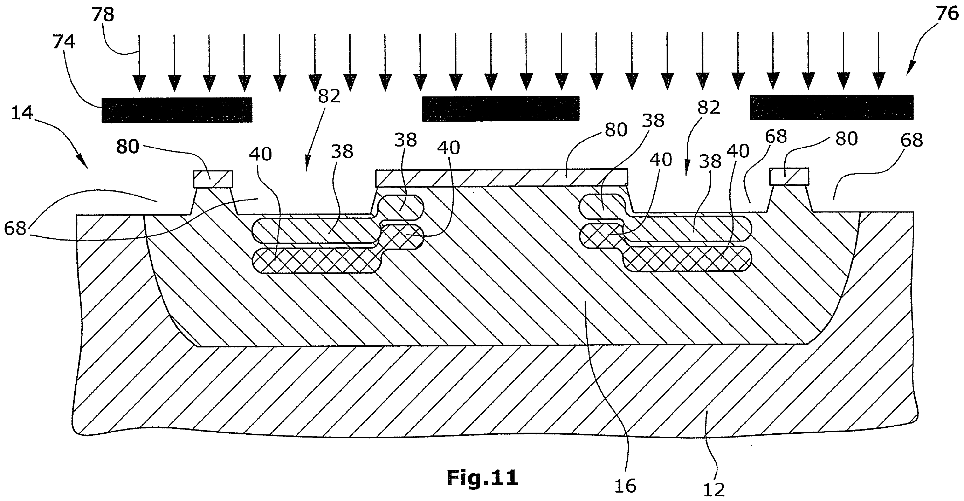

In den Fign. 10 bis 12 sind die einzelnen Verfahrensschritte eines STI-Prozesses zur Herstellung des NMOS-Transistors 10 gezeigt, wobei in diesem Ausführungsbeispiel die n-Wanne 16 vollständig ausgebildet ist. Fig. 11 zeigt die Situation bei der Einbringung der Implantationen für die n-Driftzone 38 und die pRESURF-Zone 40. Die zur Ausbildung der Oberseitenvertiefungen 68 erforderliche Abdeckschicht 80 (Hartmaske) ist bereits in dem Verfahrensstadium gemäß Fig. 10 aufgebracht. Fig. 11 zeigt, wie sich in den Öffnungen 82 dieser Abdeckschicht 80 die Vertiefungen 68 in der Oberseite 14 des p-Halbleitersubstrats 12 gebildet haben.

Für die Implantation bzw. Implantationen der n-Driftzone 38 und der pRESURF-Zone 40 dient eine Implantationsmaske 72 mit Öffnungen 74, wobei bei 76 wiederum die Implantation angedeutet ist. Die Implantationen werden also innerhalb der Vertiefungen 68 direkt in die n-Wanne 16 eingeschossen, während sie seitlich dieser Vertiefungen 68 erst durch die noch vorhandene Abdeckschicht 80 hindurchtreten müssen, um dann in die n-Wanne 16 zu gelangen. Dadurch entstehen versetzte Bereiche innerhalb beider Zone 38,40.

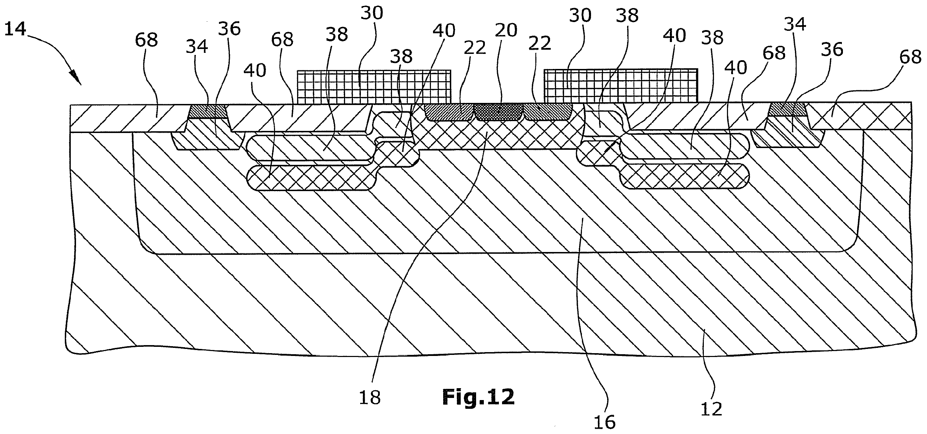

Die Komplettdarstellung des NMOS-Transistors zeigt Fig. 12. Zu erkennen ist wiederum, dass die pRESURF-Zone 40 trotz des topologisch bedingten Versatzes innerhalb der Zone elektrisch an das pBody-Gebiet 18 angebunden ist.

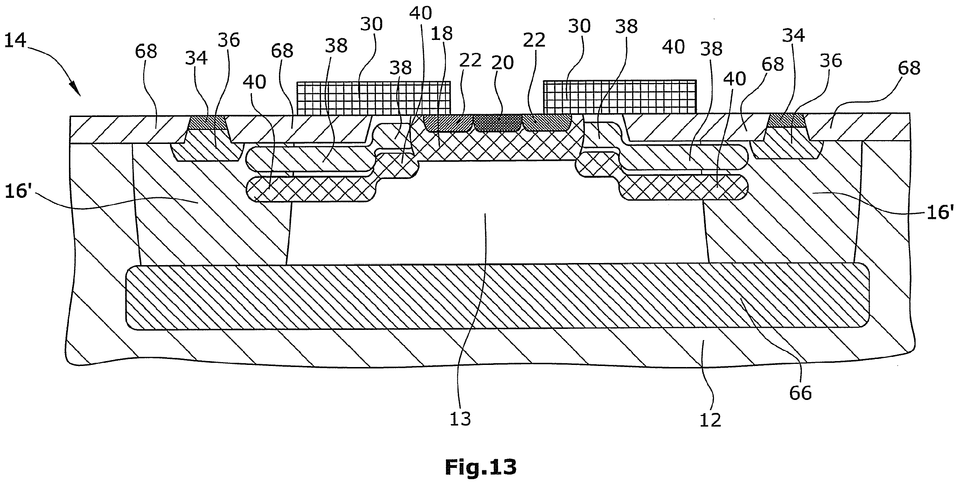

Fig. 13 zeigt eine Schnittdarstellung eines unter Verwendung eines STI-Prozesses hergestellten NMOS-Transistors ähnlich demjenigen gemäß Fig. 9.

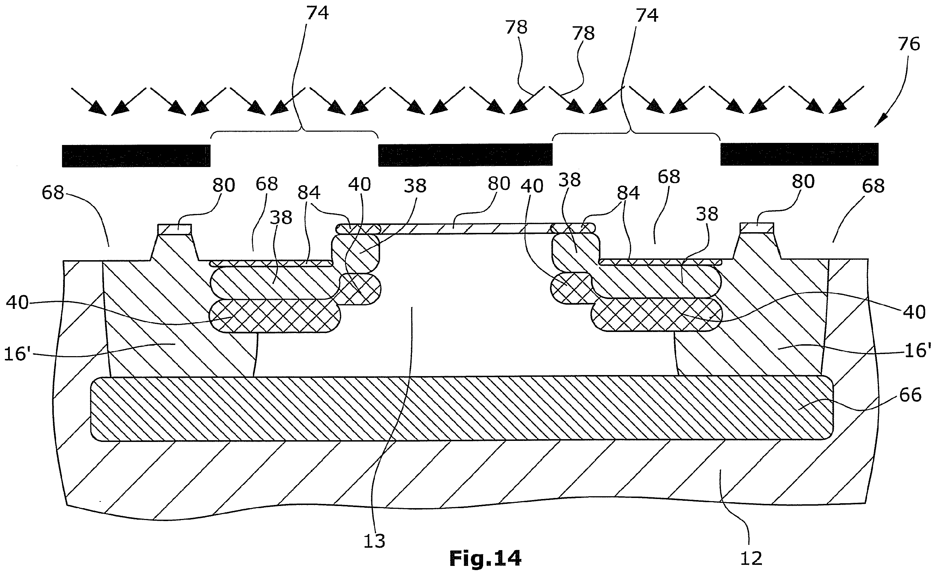

In den Fign. 14 bis 16 ist ein weiteres Beispiel für ein Verfahren zur Herstellung des NMOS-Transistors mittels STI-Technologie unter Erzeugung einer zusätzlichen p-dotierten Zone oberhalb der n-Driftzone 38 gezeigt. Wiederum wird in diesem Fall davon ausgegangen, dass die n-Wanne 16 aus mindestens zwei getrennt eingebrachten Wannengebieten 16' und damit noch unvollständig ausgebildet ist.

Gemäß Fig. 14 sind bereits in die Oberseite 14 des p-Halbleitersubstrats 12 die Vertiefungen 68 ausgebildet, wobei außerhalb der Vertiefungen 68 noch die Abdeckschicht 80 (Hartmaske) vorhanden ist. Diese Abdeckschicht 80 resultiert noch aus dem vorhergehenden STI-Prozessschritt, bei dem die Vertiefungen 68 gebildet werden. Vor dem Auffüllen der Oberseitenvertiefungen 68 wird nun gemäß Fig. 14 implantiert, und zwar unter Verwendung einer Implantationsmaske 72 mit Öffnungen 74. Ferner sei davon ausgegangen, dass bereits die Implantationen für die n-Driftzone 38 und für die pRESURF-Zone 40 eingebracht sind. Die entstehenden Dotierstoffkonzentrationen und Profile mit ihren geometrischen Ausgestaltungen sind in Fig. 14 gezeigt.

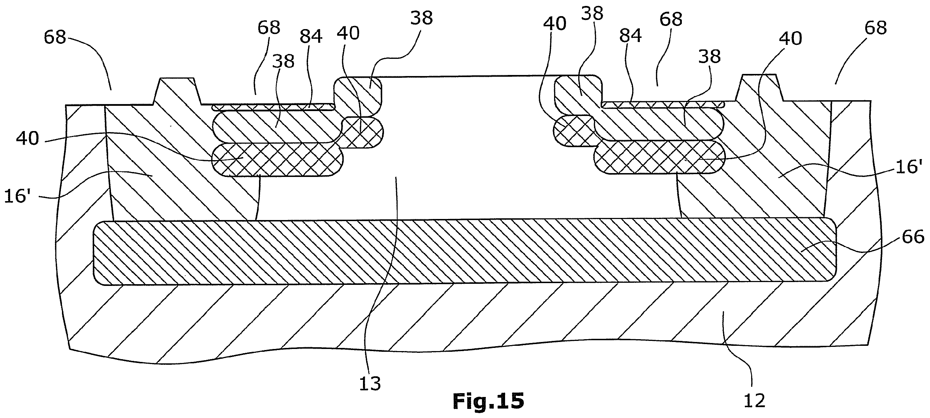

Zusätzlich wird nun bei diesem Herstellungsverfahren oberhalb der n-Driftzone 38 noch eine zusätzliche p-dotierte Zone 84 mit vergleichsweise geringer Eindringtiefe eingebracht. Durch die Entfernung der Abdeckschicht 80 verbleibt diese zusätzliche oberflächennahe p-Dotierung 84 nur im Bereich der Vertiefungen 68 und eventuell an entsprechenden Seitenwänden, nicht jedoch im Kanal-Anschlussgebiet außerhalb den Vertiefungen 68. Nach Entfernung der Abdeckschicht 80 ergibt sich somit die Situation gemäß Fig. 15. In Fig. 14 ist die vorteilhafte Verwendung von nicht senkrechten Ionen-Einfallswinkeln auf die strukturierte Oberseite 14 des p-Halbleitersubstrats 12 in einem oder auch mehreren Implantationsschritten dargestellt, welche für die Herstellung der n-Driftzone 38, der pRESURF-Zone 40 oder der zusätzlichen p-dotierten Zone 84 benutzt werden, was durch die Pfeile 78 dargestellt ist.

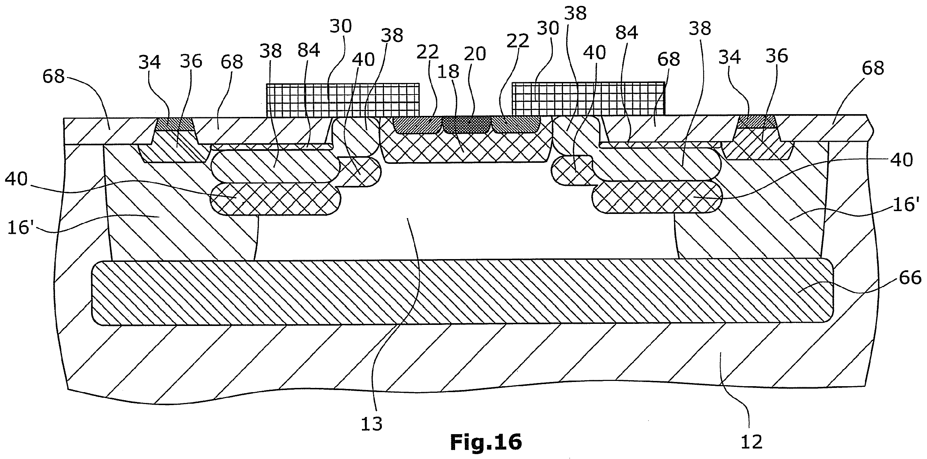

Den vollständigen Aufbau des NMOS-Transistors mit den wesentlichen, im Rahmen dieser Erfindung zu beschreibenden Komponenten zeigt Fig. 16.

Insbesondere was das letzte Ausführungsbeispiel betrifft, ist in fertigungstechnischer Hinsicht mit Vorteil anzumerken, dass innerhalb dieses Verfahrens auf die Verwendung von Implantationsschritten mit hoher Energie, d.h. oberhalb von z.B. ca. 600 keV Beschleunigungsenergie, verzichtet werden kann.

### BEZUGSZEICHENLISTE

- 10: NMOS-Transistor
- 12: Halbleitersubstrat
- 13: Zwischenraum zwischen implantierten Wannenteilgebieten
- 14: Halbleitersubstratoberseite
- 16: n-Wanne
- 16': Teilgebiete der n-Wanne (bei unvollständig ausgebildeter n-Wanne)
- 18: pBody-Gebiet
- 19: Kanalgebiet
- 20: Anschlussgebiet des pBody
- 22: Source-Anschlussgebiet
- 24: Feldoxidbereiche
- 26: Gate
- 28: Gate-Isolationsschicht
- 30: Gate-Elektrode
- 32: Feldplatte
- 34: Drain-Anschlussgebiet
- 36: Verstärkungszone am Drain-Anschlussgebiet
- 38: n-dotierte Driftzone
- 38': n-Dotierstoff-Implantationsgebiet
- 40: pRESURF-Zone
- 42: Unterseite des pBody-Gebiets
- 44: Abstand zwischen pRESURF-Zone und Boden der n-Wanne
- 46: Boden der n-Wanne
- 48: Parasitärer pnp-Transistor
- 50: Basis des parasitären pnp-Transistors
- 52: Emitter des parasitären pnp-Transistors
- 54: Kollektor des parasitären pnp-Transistors
- 56: Abdeckschicht
- 58: Öffnungen in der Abdeckschicht
- 60: Implantationsmaske
- 62: Öffnungen in der Implantationsmaske
- 64: Pfeile (Richtung der Implantation)
- 66: vergrabene Schicht (buried layer)
- 68: Oberseitenvertiefungen (shallow trenches) des p-Halbleitersubstrats
- 70: Isolationsmaterial
- 72: Implantationsmaske
- 74: Öffnungen in der Implantationsmaske
- 76: Implantation
- 78: Pfeile (zur Darstellung der Implantationsrichtung)
- 80: Abdeckschicht
- 82: Öffnungen in der Abdeckschicht
- 84: oberseitennahe p-dotierte Zone

## Patentansprüche

1. Verfahren zur Herstellung eines NMOS-Transistors , insbesondere für hohe Substratspannungen, mit
- einem p-dotierten p-Halbleitersubstrat (12) mit einer Oberseite (14),
- einer in die Oberseite (14) durch Ionenimplantation und thermische Diffusion eingebrachten n-dotierten n-Wanne (16),
- einem innerhalb der n-Wanne (16) ausgebildeten, bis zur Oberseite (14) des p-Halbleitersubstrats (12) reichenden p-dotierten, ein Anschlussgebiet (20) aufweisenden pBody-Gebiet (18), in dem ein halbleitersubstratoberseitiges, n-dotiertes Source-Anschlussgebiet (22) und ein halbleitersubstratoberseitiges Kanalgebiet (19) ausgebildet sind,
- einem innerhalb der n-Wanne (16) ausgebildeten halbleitersubstratoberseitigen n-dotierten Drain-Anschlussgebiet (34),
- einer zusätzlichen, innerhalb der n-Wanne (16) ausgebildeten n-dotierten Driftzone (38), die sich zwischen dem pBody-Gebiet (18) und dem n-dotierten Drain-Anschlussgebiet (34) erstreckt,
- einer in der n-Wanne (16) unterhalb der n-dotierten Driftzone (38) ausgebildeten p-dotierten pRESURF-Zone (40) und
- einem eine Gate-Isolationsschicht (28) und eine Gate-Elektrode (30) auf dieser aufweisenden Gate (26), das auf der Halbleitersubstratoberseite (14) angeordnet ist und sich über dem pBody-Gebiet (18) und bis über die n-dotierte Driftzone (38) erstreckt,
- wobei die p-dotierte pRESURF-Zone (40) seitlich neben dem pBody-Gebiet (18) liegt, wobei die der Oberseite (14) des Halbleitersubstrats (12) abgewandte Unterseite (42) des pBody-Gebiets (18) in mindestens einem Teilgebiet direkt an die n-Wanne (16) stößt, und
- wobei die pRESURF-Zone (40)
- mit dem pBody-Gebiet (18) elektrisch leitend verbunden ist oder
- metallurgisch mit dem pBody-Gebiet (18) verbunden ist, beide also ineinander übergehen, oder
- an das pBody-Gebiet (18) elektrisch leitend angebunden ist,
**dadurch gekennzeichnet,**
- **dass** ein LOCOS-Prozess verwendet wird, bei dem zur Erzeugung von einzelnen, örtlich begrenzten Oxidgebieten auf der Oberseite (14) des Halbleitersubstrats (12) auf diesem bereichsweise eine Abdeckschicht (56) aus einem eine Oberflächenoxidation des Halbleitersubstrats (12) verhindernden Material aufgebracht wird, wobei mindestens eine Ionenimplantation unter Verwendung einer Implantationsmaske (60) zur Erzeugung der n-dotierten Driftzone (38) und/oder der p-dotierten pRESURF-Zone (40) zu einem Zeitpunkt der Herstellung des NMOS-Transistors erfolgt, zu dem die Abdeckschicht (56) noch nicht von der Oberseite (14) des Halbleitersubstrats (12) abgetragen ist, die Implantationsmaske also auf die örtlich begrenzten Oxidgebieten (24,32) und der komplementäre Abdeckschicht (56) aufgetragen wird.

2. Verfahren zur Herstellung eines NMOS-Transistors, insbesondere für hohe Substratspannungen, mit
- einem p-dotierten p-Halbleitersubstrat (12) mit einer Oberseite (14),
- einer in die Oberseite (14) durch Ionenimplantation und thermische Diffusion eingebrachten n-dotierten n-Wanne (16),
- einem innerhalb der n-Wanne (16) ausgebildeten, bis zur Oberseite (14) des p-Halbleitersubstrats (12) reichenden p-dotierten, ein Anschlussgebiet (20) aufweisenden pBody-Gebiet (18), in dem ein halbleitersubstratoberseitiges, n-dotiertes Source-Anschlussgebiet (22) und ein halbleitersubstratoberseitiges Kanalgebiet (19) ausgebildet sind,
- einem innerhalb der n-Wanne (16) ausgebildeten halbleitersubstratoberseitigen n-dotierten Drain-Anschlussgebiet (34),
- einer zusätzlichen, innerhalb der n-Wanne (16) ausgebildeten n-dotierten Driftzone (38), die sich zwischen dem pBody-Gebiet (18) und dem n-dotierten Drain-Anschlussgebiet (34) erstreckt,
- einer in der n-Wanne (16) unterhalb der n-dotierten Driftzone (38) ausgebildeten p-dotierten pRESURF-Zone (40) und
- einem eine Gate-Isolationsschicht (28) und eine Gate-Elektrode (30) auf dieser aufweisenden Gate (26), das auf der Halbleitersubstratoberseite (14) angeordnet ist und sich über das pBody-Gebiet (18) und bis über die n-dotierte Driftzone (38) erstreckt,
- wobei die p-dotierte pRESURF-Zone (40) seitlich neben dem pBody-Gebiet (18) liegt, wobei die der Oberseite (14) des Halbleitersubstrats (12) abgewandte Unterseite (42) des pBody-Gebiets (18) in mindestens einem Teilgebiet direkt an die n-Wanne (16) stößt, und
- wobei die pRESURF-Zone (40)
- mit dem pBody-Gebiet (18) elektrisch leitend verbunden ist oder
- metallurgisch mit dem pBody-Gebiet (18) verbunden ist, beide also ineinander übergehen,
oder
- an das pBody-Gebiet (18) elektrisch leitend angebunden ist,
**dadurch gekennzeichnet,**
- **dass** ein STI-Prozess verwendet wird, bei dem zur Erzeugung von einzelnen, örtlich begrenzten Isolationsgebieten auf der Oberseite (14) des Halbleitersubstrats (12) auf diesem bereichsweise eine Abdeckschicht (80) aus einem eine Ätzung des Halbleitersubstrats (12) verhindernden Material aufgebracht wird, wobei mindestens eine Ionenimplantation unter Verwendung einer Implantationsmaske zur Erzeugung der n-dotierten Driftzone (38) und/oder der p-dotierten pRESURF-Zone (40) zu einem Zeitpunkt der Herstellung des NMOS-Transistors erfolgt, zu dem die Abdeckschicht (80) noch nicht von der Oberseite (14) des Halbleitersubstrats (12) abgetragen ist, die Implantationsmaske (76) also auf die Oberseite (14) des Halbleitersubstrats (12) und der Abdeckschicht (80) aufgetragen wird.

3. Verfahren nach Anspruch 2, **dadurch gekennzeichnet, dass** mindestens eine Ionenimplantation zu einem Zeitpunkt erfolgt, zu dem die Ätzung des Halbleitersubstrats (12) noch nicht durchgeführt ist.

4. Verfahren nach Anspruch 2, **dadurch gekennzeichnet, dass** mindestens eine Ionenimplantation zu einem Zeitpunkt erfolgt, zu dem die Ätzung des Halbleitersubstrats (12) bereits durchgeführt ist.

5. Verfahren nach Anspruch 2, **dadurch gekennzeichnet, dass** mindestens eine Ionenimplantation zu einem Zeitpunkt erfolgt, zu dem die geätzten STI-Gräben noch nicht bzw. noch nicht vollständig aufgefüllt sind.

6. Verfahren nach einem der Ansprüche 1 bis 5, **dadurch gekennzeichnet, dass** für die Ionenimplantationen zur Bildung der n-dotierten Driftzone (38) und der p-dotierten pRESURF-Zone (40) dieselbe Implantationsmaske verwendet wird.

7. Verfahren nach einem der Ansprüche 1 bis 6, **dadurch gekennzeichnet, dass** die Tiefe und Ausdehnung der n-dotierten Driftzone (38) bzw. der p-dotierten pRESURF-Zone (40) ohne gezielte thermische Diffusion im Wesentlichen durch die Implantationsparameter (Energie und Einschusswinkel) definiert ist.

## Claims

1. A method for manufacturing an NMOS transistor, in particular for high substrate voltages, comprising
- a p-doped p-semiconductor substrate (12) having an upper side (14),
- an n-doped n-well (16) introduced into the upper side (14) by ion implantation and thermal diffusion,
- a p-doped pbody region (18) formed in the n-well (16), reaching up to the upper side (14) of the p-semiconductor substrate (12) and comprising a connecting region (20), in which pbody region an n-doped source connecting region (22) on the upper side of the semiconductor substrate and a channel region (19) on the upper side of the semiconductor region are formed,
- an n-doped drain connecting region (34) on the upper side of the semiconductor substrate and formed in the n-well (16),
- an additional n-doped drift zone (38) formed in the n-well (16), which drift zone extends between the pbody region (18) and the n-doped drain connecting region (34),
- a p-doped pRESURF zone (40) formed in the n-well (16) below the n-doped drift zone (38), and
- a gate (26) comprising a gate isolation layer (28) and a gate electrode (30) provided thereon, which gate is arranged on the upper side (14) of the semiconductor substrate and extends across the pbody region (18) and across the n-doped drift zone (38),
- wherein the n-doped pRESURF zone (40) lies laterally next to the pbody region (18), wherein the lower side (42) of the pbody region (18) facing away from the upper side (14) of the semiconductor substrate (12) directly abuts on the n-well (16) at least in one subregion, and
- wherein the pRESURF zone (40)
- is connected to the pbody region (18) in an electrically conducting manner
or
- is metallurgically connected to the pbody region (18), that is both transition into each other,
or
- is connected to the pbody region (18) in an electrically conducting manner,
**characterized in that**
- a LOCOS process is used, where a cover layer (56) of a material preventing oxidation of the surface of the semiconductor substrate (12) is applied in some regions for producing individual localized oxide regions on the upper side (14) of the semiconductor substrate (12), wherein at least one ion implantation is carried out using an implantation mask (60) for producing the n-doped drift zone (38) and/or the p-doped pRESURF zone (40) at a time during the manufacture of the NMOS transistor when the cover layer (56) has not yet been removed from the upper side (14) of the semiconductor substrate (12), that is the implantation mask is applied to the localized oxide regions (24, 32) and the complementary cover layer (56).

2. A method for manufacturing an NMOS transistor, in particular for high substrate voltages, comprising
- a p-doped p-semiconductor substrate (12) having an upper side (14),
- an n-doped n-well (16) introduced into the upper side (14) by ion implantation and thermal diffusion,
- a p-doped pbody region (18) formed in the n-well (16), reaching up to the upper side (14) of the p-semiconductor substrate (12) and comprising a connecting region (20), in which pbody region an n-doped source connecting region (22) on the upper side of the semiconductor substrate and a channel region (19) on the upper side of the semiconductor region are formed,
- an n-doped drain connecting region (34) on the upper side of the semiconductor substrate and formed in the n-well (16),
- an additional n-doped drift zone (38) formed in the n-well (16), which drift zone extends between the pbody region (18) and the n-doped drain connecting region (34),
- a p-doped pRESURF zone (40) formed in the n-well (16) below the n-doped drift zone (38), and
- a gate (26) comprising a gate isolation layer (28) and a gate electrode (30) provided thereon, which gate is arranged on the upper side (14) of the semiconductor substrate and extends across the pbody region (18) and across the n-doped drift zone (38),
- wherein the n-doped pRESURF zone (40) lies laterally next to the pbody region (18), wherein the lower side (42) of the pbody region (18) facing away from the upper side (14) of the semiconductor substrate (12) directly abuts on the n-well (16) at least in one subregion, and
- wherein the pRESURF zone (40)
- is connected to the pbody region (18) in an electrically conducting manner
or
- is metallurgically connected to the pbody region (18), that is both transition into each other,
or
- is connected to the pbody region (18) in an electrically conducting manner,
**characterized in that**
- an STI process is used, where a cover layer (80) of a material preventing etching of the semiconductor substrate (12) is applied in some regions for producing individual localized isolation regions on the upper side (14) of the semiconductor substrate (12), wherein at least one ion implantation is carried out using an implantation mask for producing the n-doped drift zone (38) and/or the p-doped pRESURF zone (40) at a time during the manufacture of the NMOS transistor when the cover layer (80) has not yet been removed from the upper side (14) of the semiconductor substrate (12), that is the implantation mask (76) is applied to the upper side (14) of the semiconductor substrate (12) and the cover layer (80).

3. The method according to claim 2, **characterized in that** at least one ion implantation is carried out at a time when etching of the semiconductor substrate (12) has not yet been performed.

4. The method according to claim 2, **characterized in that** at least one ion implantation is carried out at a time when etching of the semiconductor substrate (12) has already been performed.

5. The method according to claim 2, **characterized in that** at least one ion implantation is carried out at a time when the etched STI trenches have not yet been filled or completely filled.

6. The method according to any one of claims 1 to 5, **characterized in that** for the ion implantation for forming the n-doped drift zone (38) and the p-doped pRESURF zone (40) the same implantation mask is used.

7. The method according to any one of claims 1 to 6, **characterized in that** the depth and extension of the n-doped drift zone (38) and the p-doped pRESURF zone (40), respectively, without any specific thermal diffusion are essentially defined by the implantation parameters (energy and angle of entry).

## Revendications

1. Procédé de fabrication d'un transistor NMOS, en particulier pour des tensions élevées du substrat, doté
- d'un substrat semi-conducteur p dopé p (12) doté d'une face supérieure (14),
- d'une cuvette n dopée n (16) introduite dans la face supérieure (14) par implantation ionique et diffusion thermique,
- d'une zone de corps dopée p (18) réalisée à l'intérieur de la cuvette n (16), dopée p jusqu'à la face supérieure (14) du substrat semi-conducteur p (12), comprenant une région de raccordement (20), une région de raccordement de source dopée n (22) étant réalisée sur la face supérieure du substrat semi-conducteur et une région canal (19) étant réalisée sur la face supérieure du substrat semi-conducteur,
- d'une région de raccordement drain dopée n (34) sur la face supérieure du substrat semi-conducteur réalisée à l'intérieur de la cuvette n (16),
- d'une zone de dérive dopée n (38) supplémentaire, réalisée à l'intérieur de la cuvette n (16), s'étendant entre la zone de corps dopée p (18) et la région de raccordement drain dopée n (34),
- d'une zone pRESURF dopée p (40) réalisée dans la cuvette n (16) en dessous de la zone de dérive dopée n (38) et
- d'une grille (26) comportant une couche d'isolation de grille (28) et une électrode de grille (30) sur celle-ci, la grille étant agencée sur la face supérieure du substrat semi-conducteur (14) et s'étend au-dessus de la zone de corps dopée p (18) et jusqu'au-dessus de la zone de dérive dopée n (38),
- dans lequel la zone pRESURF dopée p (40) se trouve latéralement voisine la zone de corps dopée p (18), dans lequel la face inférieure (42) de la zone de corps dopée p (18) se détournant de la face supérieure (14) du substrat semi-conducteur (12) heurte directement la cuvette n (16) dans au moins une région partielle, et
- dans lequel la zone pRESURF (40)
∘ est reliée de manière électriquement conductrice à la zone de corps dopée p (18) ou
∘ est reliée de manière métallurgique à la zone de corps dopée p (18), les deux se fondant ainsi l'une dans l'autre, ou
∘ est raccordée de manière électriquement conductrice sur la zone de corps dopée p (18),
- **caractérisé en ce qu'**un processus LOCOS est utilisé, lors duquel, pour obtenir des régions d'oxyde individuelles et localement limitées sur la face supérieure (14) du substrat semi-conducteur (12), une couche de revêtement (56) en matériau empêchant une oxydation de surface du substrat semi-conducteur (12) est déposée par endroits sur celui-ci, dans lequel afin d'obtenir la zone de dérive dopée n (38) et/ou la zone pRESURF dopée p (40) au moins une implantation ionique utilisant un masque d'implantation (60) est effectuée à un moment de la fabrication du transistor NMOS auquel la couche de revêtement (56) n'a pas encore été éliminée de la face supérieure (14) du substrat semi-conducteur (12), le masque d'implantation étant donc sur les régions d'oxyde localement limitées (24, 32) et la couche de revêtement (56) complémentaire est appliquée.

2. Procédé de fabrication d'un transistor NMOS, en particulier pour des tensions élevées du substrat, doté
- d'un substrat semi-conducteur p dopé p (12) doté d'une face supérieure (14),
- d'une cuvette n dopée n (16) introduite dans la face supérieure (14) par implantation ionique et diffusion thermique,
- d'une zone de corps dopée p (18) réalisée à l'intérieur de la cuvette n (16), dopée p jusqu'à la face supérieure (14) du substrat semi-conducteur p (12), comprenant une région de raccordement (20), une région de raccordement de source dopée n (22) étant réalisée sur la face supérieure du substrat semi-conducteur et une région canal (19) étant réalisée sur la face supérieure du substrat semi-conducteur,
- d'une région de raccordement drain dopée n (34) sur la face supérieure du substrat semi-conducteur réalisée à l'intérieur de la cuvette n (16),
- d'une zone de dérive dopée n (38) supplémentaire, réalisée à l'intérieur de la cuvette n (16), s'étendant entre la zone de corps dopée p (18) et la région de raccordement drain dopée n (34),
- d'une zone pRESURF dopée p (40) réalisée dans la cuvette n (16) en dessous de la zone de dérive dopée n (38) et
- d'une grille (26) comportant une couche d'isolation de grille (28) et une électrode de grille (30) sur celle-ci, la grille étant agencée sur la face supérieure du substrat semi-conducteur (14) et s'étend au-dessus de la zone de corps dopée p (18) et jusqu'au-dessus de la zone de dérive dopée n (38),
- dans lequel la zone pRESURF dopée p (40) se trouve latéralement voisine la zone de corps dopée p (18), dans lequel la face inférieure (42) de la zone de corps dopée p (18) se détournant de la face supérieure (14) du substrat semi-conducteur (12) heurte directement la cuvette n (16) dans au moins une région partielle, et
- dans lequel la zone pRESURF (40)
∘ est reliée de manière électriquement conductrice à la zone de corps dopée p (18) ou
∘ est reliée de manière métallurgique à la zone de corps dopée p (18), les deux se fondant ainsi l'une dans l'autre, ou
∘ est raccordée de manière électriquement conductrice sur la zone de corps dopée p (18),
- **caractérisé en ce qu'**un processus STI est utilisé, lors duquel, pour obtenir des régions d'isolation individuelles et localement limitées sur la face supérieure (14) du substrat semi-conducteur (12), une couche de revêtement (80) en matériau empêchant une gravure du substrat semi-conducteur (12) est déposée par endroits sur celui-ci, dans lequel afin d'obtenir la zone de dérive dopée n (38) et/ou la zone pRESURF dopée p (40) au moins une implantation ionique utilisant un masque d'implantation est effectuée à un moment de la fabrication du transistor NMOS auquel la couche de revêtement (80) n'a pas encore été éliminée de la face supérieure (14) du substrat semi-conducteur (12), le masque d'implantation (76) étant donc sur la face supérieure (14) du substrat semi-conducteur (12) et la couche de revêtement (80) est appliquée.

3. Procédé selon la revendication 2, **caractérisé en ce qu'**au moins une implantation ionique s'effectue à un moment auquel la gravure du substrat semi-conducteur (12) n'a pas encore été réalisée.

4. Procédé selon la revendication 2, **caractérisé en ce qu'**au moins une implantation ionique s'effectue à un moment auquel la gravure du substrat semi-conducteur (12) a déjà été réalisée.

5. Procédé selon la revendication 2, **caractérisé en ce qu'**au moins une implantation ionique s'effectue à un moment auquel les tranchées STI gravées n'ont pas encore été remplies ou pas encore été complètement remplies.

6. Procédé selon l'une des revendications 1 à 5, **caractérisé en ce que** le même masque d'implantation est utilisé pour les implantations ioniques destinées à former la zone de dérive dopée n (38) et la zone pRESURF dopée p (40).

7. Procédé selon l'une des revendications 1 à 6, **caractérisé en ce que** la profondeur et l'étendue de la zone de dérive dopée n (38) ou de la zone pRESURF dopée p (40) sont définies sans diffusion thermique ciblée essentiellement par les paramètres d'implantation (énergie et angle d'entrée).
